# EUROPEAN PATENT APPLICATION

(11) **EP 2 043 167 A1**
(43) Date of publication of application: **01.04.2009**
(21) Application number: 08739137.1
(22) Date of filing: 28.03.2008
(51) Int. Cl.: H01L 33/00, H01L 21/205

(54) **NITRIDE SEMICONDUCTOR LIGHT EMITTING DEVICE AND PROCESS FOR PRODUCING THE SAME**

(30) Priority: 06.04.2007 JP 2007100930
(71) Applicant: Sumitomo Electric Industries, Ltd., Chuo-ku Osaka-shi Osaka 541-0041 (JP)
(72) Inventor: AKITA, Katsushi, Itami-shi Hyogo 664-0016 (JP); KYONO, Takashi, Itami-shi Hyogo 664-0016 (JP); ISHIBASHI, Keiji, Itami-shi Hyogo 664-0016 (JP); KASAI, Hitoshi, Itami-shi Hyogo 664-0016 (JP)
(74) Representative: Grünecker, Kinkeldey, Stockmair & Schwanhäusser Anwaltssozietät
(86) International application number: PCT/JP2008/056013
(87) International publication number: WO 2008/126695

(57) **Abstract**

An active layer 17 is provided so as to emit light having an emission wavelength in the 440 nm to 550 nm band. A first-conductivity-type gallium nitride semiconductor region 13, the active layer 17, and a second-conductivity-type gallium nitride semiconductor region 15 are arranged along a predetermined axis *Ax.*

The active layer 17 includes a well layer composed of hexagonal In*ₓ*Ga_{1-*x*}N (0.16 ≤ *x* ≤ 0.4, *x*: strained composition), with the indium fraction *x* is represented by the strained composition. The *m*-plane of the hexagonal InₓGa_{1-*x*}N is oriented along the predetermined axis *Ax.* The well-layer thickness is between greater than 3 nm and less than or equal to 20 nm. Having the well-layer thickness be over 3 nm makes it possible to fabricate light-emitting devices having an emission wavelength of over 440 nm.

## Description

### Technical Field

The present invention relates to nitride semiconductor light-emitting devices, and to methods of fabricating nitride semiconductor light-emitting devices.

### Background Art

Light-emitting diodes are discussed in Non-Patent Document 1. The light-emitting diodes are formed onto the *m*-plane, free of dislocations, of a high-resistivity GaN substrate, and have a 5-period Si-doped InGaN/GaN quantum-well structure. The InGaN well layer is doped with Si, and is 3 nm in thickness. The GaN barrier layer is 9 nm. Gallium nitride semiconductor growth onto the *m*-plane is carried out under growth conditions optimized for *c*-plane GaN. After epoxy encapsulation, the peak wavelength at an applied current of 20 milliamperes was 435 nm, the optical output power was 1.79 milliwatts, and the external quantum efficiency was 3.1%.

Light-emitting diodes are discussed in Non-Patent Document 2. The light-emitting diodes are formed onto low-dislocation *m*-plane GaN substrates, with the carrier density of the GaN substrates being 1 × 10¹⁷ cm⁻³. The light-emitting diodes have a 6-period InGaN/GaN quantum-well structure. The InGaN well-layer thickness is 8 nm. The GaN barrier layer is 16 nm. Gallium nitride semiconductor growth onto the *m*-plane is almost the same as growth conditions optimized for *c*-plane GaN. After polymer encapsulation, the peak wavelength at an applied current of 20 milliamperes was 407 nm, the output power was 23.7 milliwatts, and the external quantum efficiency was 38.9%.

Laser diodes having an In_{0.1}Ga_{0.9}N active layer provided on GaN (1-100) substrates are discussed in Patent Document 1. Also discussed are surface-emitting laser diodes having In_{0.15}Ga_{0.85}N well layers and In_{0.05}Ga_{0.95}N barrier layers, provided on a high-resistivity SiC (11-20) substrate. Furthermore, surface-emitting laser diodes having 4 nm In_{0.2}Ga_{0.8}N well layers and 4 nm In_{0.05}Ga_{0.95}N barrier layers, provided on the (1-100) plane or (11-20) plane of a high-resistivity SiC substrate are discussed.
Non-Patent Document 1: Japanese Journal of Applied Physics, Vol. 45, No. 45, 2006, pp. L1197-L1199.
Non-Patent Document 2: Japanese Journal of Applied Physics, Vol. 46, No. 7, 2007, pp. L126-L128 (UCSB).
Patent Document 1: Japanese Unexamined Pat. App. Pub. No. H10-135576.

### Disclosure of Invention

### Problems Invention Is to Solve

In semiconductor light-emitting devices having active layers composed of a gallium nitride semiconductor, since so-called *c*-plane GaN substrates are employed, influences originating in the piezoelectric effect appear in the active layer. On the other hand, even with GaN the *m*-plane has been demonstrated to be non-polar, thanks to which it is anticipated that the active layers will not undergo influences originating in the piezo effect. Non-Patent Documents 1 and 2 set forth light-emitting diodes of an InGaN/GaN quantum-well structure, fabricated on the *m*-plane. Patent Document 1 mentions InGaN active layers and InGaN well layers having several indium fractions, but hardly says anything specific concerning emission wavelength or emission intensity.

Light-emitting diodes having an emission wavelength longer than the peak wavelengths of the light-emitting diodes of Non-Patent References 1 and 2 are being sought. According to experiments by the inventors, however, if a quantum-well structure is formed onto *m*-plane GaN using the deposition protocol for forming quantum-well structures onto *c*-plane GaN, the desired photoluminescence wavelength cannot be obtained. Furthermore, results of the various experiments are that light-emitting devices with an InGaN active layer formed onto *m*-plane GaN demonstrate tendencies that differ from light-emitting devices with an InGaN active layer formed onto *c*-plane GaN, not only in photoluminescence wavelength but also in emission intensity.

An object of the present invention, brought about in consideration of such circumstances, is to make available nitride semiconductor light-emitting devices employing a non-polar gallium nitride semiconductor and of a structure that affords advantageous emission intensity, and to make available methods of fabricating nitride semiconductor light-emitting devices that employ a non-polar gallium nitride semiconductor and that afford advantageous emission intensity.

### Means for Resolving the Problems

According to one aspect of the present invention, a nitride semiconductor light-emitting device is furnished with: (a) a gallium nitride semiconductor region of a first conductivity type; (b) a gallium nitride semiconductor region of a second conductivity type; and (c) an active layer that emits light of wavelength in the 440 nm to 550 nm band, provided between the first-conductivity-type gallium nitride semiconductor region and the second-conductivity-type gallium nitride semiconductor region. The active layer includes a well layer composed of hexagonal In*ₓ*Ga_{1-*x*}N (0.16 ≤ *x* ≤ 0.4, indium fraction *x*: strained composition); the thickness D of the well layer is greater than 3 nm and the well-layer thickness Dis 20 nm or less; the thickness *D* by the indium fraction x lies in the relationship *x* ≥ -0.16 x D + 0.88; the first-conductivity-type gallium nitride semiconductor region, the active layer, and the second-conductivity-type gallium nitride semiconductor region are arranged along a predetermined axis; and the *m*-plane of the hexagonal In*ₓ*Ga_{1-*x*}N is oriented along the predetermined axis.

According to this nitride semiconductor light-emitting device, since the *m*-plane of the hexagonal InₓGa_{1-*x*}N in the well layer is oriented along the predetermined axis, the active layer exhibits substantial non-polarity. Furthermore, the well layer is composed of the hexagonal In*ₓ*Ga_{1-*x*}N (0.16 ≤ *x* ≤ 0.4, *x*: strained composition). The indium fraction in this non-polar InGaN well layer is greater by comparison with the indium fraction in non-polar InGaN well layers of nitride semiconductor light-emitting devices formed using *c-*plane film-deposition protocols. For this reason, the emission intensity of a nitride semiconductor light-emitting device in the present case is advantageous over nitride semiconductor light-emitting devices according to *c*-plane film-deposition protocols. Moreover, since the well layer is composed of hexagonal In*ₓ*Ga_{1-*x*}N (0.16 ≤ *x* ≤ 0.4, *x*: strained composition), and since the well-layer thickness is between greater than 3 nm and less than or equal to 20 nm, a quantum-well structure such as to generate an emission wavelength in the 440 nm to 550 nm band.

In the nitride semiconductor light-emitting device involving the present invention, the active layer may include a barrier layer composed of hexagonal In*_{y}*Ga_{1-*y*}N (0 ≤ *y* ≤ 0.05, *y*: strained composition).

According to the nitride semiconductor light-emitting device, the active layer may have a quantum-well structure, and the hexagonal In*_{y}*Ga_{1-*y*}N (0 ≤ *y* ≤ 0.05, *y*: strained composition) is suited to indium fraction for the non-polar InGaN barrier layer.

The nitride semiconductor light-emitting device involving the present invention may further include a substrate constituted of hexagonal Al*_{z}*Ga_{1-*z*}N semiconductor (0 ≤ *z* ≤1). The first-conductivity-type gallium nitride semiconductor region, active layer and second-conductivity-type gallium nitride semiconductor region are carried on the principal face of the substrate.

According to the nitride semiconductor light-emitting device, the first-conductivity-type gallium nitride semiconductor region, the active layer, and the second-conductivity-type gallium nitride semiconductor region can be formed onto the hexagonal Al*_{z}*Ga_{1-*z*}N semiconductor, which leads to improvement of their crystallinity.

In the nitride semiconductor light-emitting device involving the present invention, the substrate principal face may be misoriented at an off-axis angle (-2° ≤ θ ≤ +2°) with respect to the *m*-plane. According to the nitride semiconductor light-emitting device, without being substantially influenced by polarity, semiconductor crystal of preferable crystallinity can be obtained.

In the nitride semiconductor light-emitting device involving the present invention, threading dislocations in the substrate extend in the *c*-axis direction. According to the nitride semiconductor light-emitting device, threading dislocations run in the *c*-axis direction, which means that the threading dislocations extend substantially parallel to the substrate principal face. Furthermore, in the nitride semiconductor light-emitting device involving the present invention, average density of threading dislocations crossing a *c*-plane of the substrate is preferably 1 × 10⁷ cm⁻² or less. According to the nitride semiconductor light-emitting device, low density of the threading dislocations crossing a *c*-plane decreases density of threading dislocations inherited during growth onto the *m*-plane principal face.

In the nitride semiconductor light-emitting device involving the present invention, the substrate include: a first region in which density of threading dislocations extending in the *c*-axis direction is higher than first threading dislocation density; and a second region in which density of threading dislocations extending in the *c*-axis direction is lower than the first threading dislocation density, with the first and second regions appearing on the substrate principal face.

According to the nitride semiconductor light-emitting device, a semiconductor grown onto the second region appearing on the *m-*plane principal face is lowered in threading dislocation density.

In the nitride semiconductor light-emitting device involving the present invention, the threading dislocation density in the second region is preferably less then 1 × 10⁷ cm⁻². According to the nitride semiconductor light-emitting device, the appearance of the second region having a threading dislocation density of less then 1 × 10⁷ cm⁻² on the *m*-plane principal face makes the semiconductor grown onto the second region very low in threading dislocation density.

Another aspect of the present invention is a nitride semiconductor light-emitting device fabricating method. The method is provided with: (a) a step of preparing a substrate constituted of a hexagonal Al*_{z}*Ga_{1-*z*}N semiconductor (0 ≤ *z* ≤ 1); (b) a step of forming a first-conductivity-type gallium nitride semiconductor film onto the principal face of the substrate; (c) a step of forming onto the first-conductivity-type gallium nitride semiconductor film an active layer that emits light having a wavelength ranging from 440 nm to 550 nm inclusive; and (d) a step of forming onto the active layer a second-conductivity-type gallium nitride semiconductor film. The first-conductivity-type gallium nitride semiconductor film, active layer, and second-conductivity-type gallium nitride semiconductor film are arranged on the substrate principal face in the predetermined-axis direction. In the active layer forming step, a first semiconductor layer, composed of hexagonal In*ₓ*Ga_{1-*x*}N (0.16 ≤ x ≤ 0.4, *x*: strained composition), having a first gallium fraction is grown at a first temperature, and in the active layer forming step, a second semiconductor layer, composed of hexagonal In*_{y}*Ga_{1-*y*}N (0 ≤ *y* ≤ 0.05, *y* < x, *y:* strained composition), having a second gallium fraction is grown at a second temperature. The first gallium fraction is lower than the second gallium fraction, and the first temperature is lower than the second temperature, with the difference between the first and second temperatures being 95 degrees or more. The *m*-plane of the hexagonal In*ₓ*Ga_{1-*x*}N faces in the predetermined-axis direction.

According to this method, in the formation of the active layer in which an *m*-plan of the hexagonal InₓGa_{1-*x*}N faces in the predetermined-axis direction, the difference in growth temperature between the two types of gallium nitride semiconductors in which the first gallium fraction is lower than the second gallium fraction is 95 degrees or more, which heightens indium fraction in the first semiconductor layer, enabling the application as a well layer.

In the method involving the present invention, from hexagonal Al*_{z}*Ga_{1-*z*}N semiconductor crystal (0 ≤ *z*≤1) grown *c*-axis oriented the substrate is sliced so as to intersect the *m*-axis, and the substrate principal face is polish-processed and stretches paralleling a plane that intersects the *m*-axis.

With this method, crystal growth proceeds in the *c*-axis direction, and thus threading dislocations also extend in the *c*-axis direction. If semiconductor plates are sliced off from the hexagonal Al*_{z}*Ga_{1-*z*}N semiconductor crystal so as to intersect with the *m*-axis, substrates suited to form active layers in which the *m*-plane of the hexagonal InₓGa_{1-*x*}N faces in the predetermined-axis direction are provided.

In the method involving the present invention, the substrate may include: a plurality of first regions in which density of threading dislocations extending in the *c*-axis direction is higher than first threading dislocation density; and a plurality of second regions in which density of threading dislocations extending in the *c*-axis is lower than the first threading dislocation density, with the first and second regions being alternately arranged, and with the first and second regions appearing on the substrate principal face.

According to the method, a semiconductor grown onto the second regions appearing on the *m*-plane principal face is lowered in threading dislocation density.

In the method involving the present invention, the threading dislocation density in the second regions is preferably less than 1 × 10⁷ cm⁻². According to this method, without being adversely affected by dislocations, semiconductor crystal of preferable crystallinity is obtained.

In the method involving the present invention, the substrate principal face may be misoriented at an off-axis angle (-2° ≤ θ ≤ +2°) with respect to the *m*-plane. According to this method, without being substantially influenced by polarity, semiconductor crystal having preferable crystallinity is obtained.

The method involving the present invention may be further provided with a step of, prior to the first-conductivity-type gallium nitride semiconductor film formation, heat-treating the substrate while a gas containing ammonia and hydrogen is supplied.

With this method, heat-treating substrates in a gas containing ammonia and hydrogen prior to gallium nitride semiconductor growth makes planar substrate surfaces obtainable, leading to fabrication of semiconductor light-emitting devices having more preferable emission properties.

The above-described object of the present invention, and other objects, characteristics and advantages will become more apparent from the following detailed description of a preferred embodiment of the present invention, with reference being made to the attached drawings.

### Effects of the Invention

As described above, the present invention affords nitride semiconductor light-emitting devices employing a non-polar gallium nitride semiconductor, and having a structure that enables providing preferable emission intensity. In addition, the present invention affords nitride semiconductor light-emitting device fabricating methods, whereby non-polar gallium nitride semiconductors are employed, and satisfactory emission intensity can be provided.

### Brief Description of Drawings

Fig. 1 is a diagram schematically depicting a nitride semiconductor light-emitting device involving a present embodiment.
Fig. 2 is a diagram illustrating one example of a gallium nitride substrate for a nitride semiconductor light-emitting device.
Fig. 3 is a diagram illustrating another example of a gallium nitride substrate for a nitride semiconductor light-emitting device.
Fig. 4 is a diagram setting forth principal process steps for fabricating a light-emitting device.
Fig. 5A is a graph plotting results of x-ray diffraction characterization (ω - 2θ scan) of the (1-100) plane.
Fig. 5B is a graph showing results of x-ray diffraction characterization (ω - 2θ scan) of the (10-10) plane.
Fig. 6 is a diagram graphing an emission spectrum obtained by applying a pulse current to a bare-chip LED at room temperature.
Fig. 7 is a graph plotting electric current - characteristic optical output power and electric current - characteristic external quantum efficiency.
Fig. 8 is a graph showing relationship between indium fraction and well-layer thickness, for an active layer provided so as to emit light of wavelength in the 440 nm to 550 nm band.
Fig. 9 is a graph showing relationship between well-layer thickness and photoluminescence (PL) wavelength.
Fig. 10 is a graph indicating emission-wavelength blue shift with increasing electric current in a LED fabricated on a *c*-plane substrate.

### Legend

- Ax:: predetermined axis
- 11:: nitride semiconductor light-emitting device
- 13:: first-conductivity-type gallium nitride semiconductor region
- 15:: second-conductivity-type gallium nitride semiconductor region
- 17:: active layer
- 19:: quantum-well structure
- 21:: cladding layer
- 23:: semiconductor layer
- 25:: electron blocking layer
- 27:: contact layer
- 29*a*:: well layers
- 29*b*:: barrier layers
- 31:: substrate
- 32a,: 32*b*: electrodes
- 33,: 35: substrates
- 33c,: 35*c*: first regions (high-dislocation regions)
- 33*d*,: 35*d*: second regions (low-dislocation regions)

### Best Mode for Carrying Out the Invention

The concepts behind present invention may be easily understood by giving consideration to the following detailed description while referring to the accompanying drawings presented as examples. With reference being made to the attached drawings, explanation will now be given of embodiments of the present invention relating to a nitride semiconductor light-emitting device, and to a nitride semiconductor light-emitting device fabricating method. When possible, identical parts have been labeled with the same reference mark.

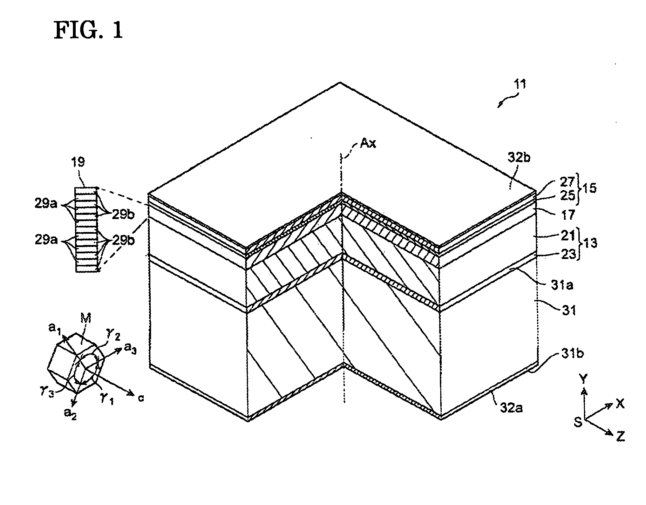

Fig. 1 is a diagram outlining a nitride semiconductor light-emitting device involving the present embodiment mode. Examples of nitride semiconductor light-emitting devices include light-emitting diodes and laser diodes. A nitride semiconductor light-emitting device 11 is provided with: a gallium nitride semiconductor region 13 of a first conductivity type; a gallium nitride semiconductor region 15 of a second conductivity type; and an active layer 17. The active layer 17 is arranged between the first-conductivity-type gallium nitride semiconductor region 13 and the second-conductivity-type gallium nitride semiconductor region 15. The active layer 17 may be composed of a single InGaN semiconductor well layer, or may have a quantum-well structure 19. The active layer 17 is provided so as to emit light having a wavelength of 440 nm or more. Also, the active layer 17 is provided so as to emit light having a wavelength in a range of 550 nm or less. The first-conductivity-type gallium nitride semiconductor region 13, the active layer 17, and the second-conductivity-type gallium nitride semiconductor region 15 are arranged along the predetermined axis *Ax.* The active layer 17 includes a well layer composed of hexagonal In*ₓ*Ga_{1-*x*}N, and the indium fraction *x* is represented by the strained composition. The *m*-plane of the hexagonal In*ₓ*Ga_{1-*x*}N is oriented along the predetermined axis *Ax.* Carriers provided from the first-conductivity-type gallium nitride semiconductor region 13 and second-conductivity-type gallium nitride semiconductor region 15 are trapped in the well layer in the active layer 17. The band gap of the first-conductivity-type gallium nitride semiconductor region 13 and of the second-conductivity-type gallium nitride semiconductor region 15 are greater by comparison with the band gap of the well layer.

Bringing the well-layer thickness to 3 nm or more enables fabricating light-emitting devices having an emission wavelength of 440 nm or more. If the well-layer thickness goes over 20 nm, InGaN crystallinity degrades, and emission properties lower.

As will be understood from the coordinates shown in Fig. 1, hexagonal In*ₓ*Ga_{1-*x*}N is represented using the *c*-axis and the three axes *a₁, a₂* and *a₃* orthogonal to the *c*-axis. The three axes *a₁, a₂* and *a₃* are at 120-degree angles (γ*₁*, γ*₂* and γ*₃*) with respect to each other. The hexagonal crystal *c*-axis points in the *z*-axis direction in orthogonal coordinate system *S*, and the axis *a₃* points in the *x*-axis direction in the orthogonal coordinate system *S.* In Fig. 1, a representative *m*-plane is illustrated.

In the nitride semiconductor light-emitting device 11 in which the *m*-plane of the hexagonal InₓGa_{1-*x*}N is oriented along the predetermined axis *Ax,* the indium fraction *x* of 0.16 or more is suited to active layers for light-emitting devices having an emission wavelength of 440 nm or more. Furthermore, if the indium fraction *x* goes over 0.4, InGaN crystallinity degrades, and emission properties lower.

The reason for this is as follows. Even if indium fraction of an InGaN light-emitting device formed onto *m*-plane GaN is the same as indium fraction of an InGaN light-emitting device formed onto *c*-plane GaN, the InGaN light-emitting device formed onto *m*-plane GaN has a shorter photoluminescence wavelength, compared with the InGaN light-emitting device formed onto *c*-plane GaN. Therefore, in InGaN light-emitting devices formed onto *m*-plane GaN, in order to obtain the desired photoluminescence wavelength, InGaN having higher indium fraction has to be grown. Furthermore, making wavelength longer than the emission wavelengths in the light-emitting diodes of Non-Patent References 1 and 2 requires further increasing indium fraction.

As described above, according to the nitride semiconductor light-emitting device 11, because the *m*-plane of the hexagonal In*ₓ*Ga_{1-*x*}N in the well layer faces in the predetermined-axis direction, the active layer 17 displays non-polarity. Furthermore, the well layer in the active layer 17 is composed of the hexagonal InₓGa_{1-*x*}N (0.16 ≤ *x* ≤ 0.4, *x*: strained composition). Indium fraction of this non-polar InGaN well layer has been brought to a greater value, relatively to indium fraction of a non-polar InGaN well layer in a nitride semiconductor light-emitting device formed under the film deposition conditions for *c*-planes, and thus the present nitride semiconductor light-emitting device is further improved in emission intensity, compared with the nitride semiconductor light-emitting device under the film deposition conditions for *c*-planes. Moreover, the active layer 17 is provided so as to emit light having an emission wavelength ranging from 440 nm to 550 nm inclusive, because the well layer in the active layer 17 is composed of the hexagonal In*ₓ*Ga_{1-*x*}N (0.16 ≤ *x* ≤ 0.4, *x*: strained composition), and the well-layer thickness is from more than 3 nm to 20 nm or less.

The first-conductivity-type gallium nitride semiconductor region 13 may include, for example, a cladding layer 21, composed of a gallium nitride semiconductor, having a band gap greater than that of the active layer, and the gallium nitride semiconductor is n-type GaN, for example. When required, the first-conductivity-type gallium nitride semiconductor region 13 may include a semiconductor layer 23 composed of an *n*-type AlGaN gallium nitride semiconductor.

The second-conductivity-type gallium nitride semiconductor region 15 may include, for example, an electron blocking layer 25, composed of a gallium nitride semiconductor, having a band gap greater than that of the active layer, and the gallium nitride semiconductor is *p*-type AlGaN, for example. The second-conductivity-type gallium nitride semiconductor region 15 may include, for example, a contact layer 27 composed of a *p*-type gallium nitride semiconductor, and the gallium nitride semiconductor is, for example, *p*-type GaN.

In a nitride semiconductor light-emitting device 11 of one embodiment, an active layer 17 may include a quantum-well structure 19. The quantum-well structure 19 may include well layers 29a and barrier layers 29b. The well layers 29a and barrier layers 29*b* are alternately arranged. In the nitride semiconductor light-emitting device 11, the well layers 29a may be composed of hexagonal In*ₓ*Ga_{1-*x*}N (0.16 ≤ *x*≤ 0.4, *x*: strained composition). Furthermore, the barrier layers 29*b* in the active layer 17 may be composed of hexagonal In*_{y}*Ga_{1*-y*}N (0 ≤ *y* ≤ 0.05, *y*: strained composition). The hexagonal In*_{y}*Ga_{1-*y*}N is suited to indium fractions for non-polar InGaN barrier layers. The hexagonal In*_{y}*Ga_{1-*y*}N may have an indium fraction of 0 or more. Also, the hexagonal In*_{y}*Ga_{1-*y*}N may have a gallium composition of 0.05 or less. This is because satisfactory energy barriers are formed between well layers. The gallium composition is represented with strained composition. The barrier layers 29*b* each may have a thickness of 5 nm or more. This is because carriers are sufficiently trapped in well layers. Furthermore, the barrier layers 29*b* each may have a thickness of 20 nm or less. This is because device resistivity low enough can be obtained. The barrier layers 29*b* are composed of, for example, GaN or InGaN.

The nitride semiconductor light-emitting device 11 may additionally include a substrate 31 constituted of hexagonal Al*_{z}*Ga_{1-*z*}N semiconductor (0 ≤ *z* ≤ 1). The substrate 31 preferably exhibits conductivity. A first-conductivity-type gallium nitride semiconductor region 13, the active layer 17, and a second-conductivity-type gallium nitride semiconductor region 15 are carried on the principal face 31a of the substrate 31. Because the first-conductivity-type gallium nitride semiconductor region 13, active layer 17, and second-conductivity-type gallium nitride semiconductor region 15 can be formed onto the hexagonal Al*_{z}*Ga_{1-*z*}N semiconductor, they are improved in crystallinity. As material of the substrate 31, GaN, AlGaN, or AlN can be utilized, for example. Preferable is that the material of the substrate 31 is n-type GaN. Onto the back side 31*b* of the substrate 31, an electrode 32a (such as cathode) is formed, and onto the contact layer 27, a different electrode 32*b* (such as anode) is formed.

The principal face 31a of the substrate 31 may parallel the *m*-plane, or may be misoriented at a given off-axis angle with respect to the *m*-plane. An off-axis angle *Angle_{OFF}* is defined by an angle formed by a normal to the principal face 31a of the substrate 31, and formed by a normal to the *m*-plane. The off-axis angle *Angle_{OFF}* may be in the angle range of -2° ≤ θ ≤ +2°, for example, in the *c*-axis direction, or may be in the angle range of -2° ≤ θ ≤ +2° in the *a*-axis direction. According to the substrate 31, without being influenced by polarity, semiconductor crystal having satisfactory crystallinity can be obtained.

In the nitride semiconductor light-emitting device 11, threading dislocations in the substrate 31 extend in the *c*-axis direction. The threading dislocations run in the *c*-axis direction, which means that they extend substantially parallel to the principal face 31*a* of the substrate 31. Furthermore, average density of threading dislocations crossing a *c*-plane of the substrate 31 is preferably 1 × 10⁷ cm⁻² (for example, density of randomly distributed threading dislocations) or less. According to the substrate 31, low density of the threading dislocations crossing a *c*-plane decreases also density of threading dislocations inherited during growth onto the *m*-plane principal face. Such a substrate 31 is sliced off from hexagonal Al*_{z}*Ga_{1-*z*}N semiconductor crystal (0 ≤ *z* ≤ 1) grown in the *c*-axis direction so as to intersect with the *m*-axis, and the principal face 31a stretches parallel to a plane that has been subjected to a polishing process, and that intersects with the *m*-axis. Growth of semiconductor crystal for the substrate 31 progresses in the *c*-axis direction, and thus threading dislocations also extend in the *c*-axis direction. In the situation in which semiconductor plates are sliced off from the hexagonal Al*_{z}*Ga_{1-*z*}N semiconductor crystal so as to intersect with the *m*-axis, the substrate 31 is suited to form an active layer in which the *m*-plane of the hexagonal In*ₓ*Ga_{1-*x*}N is oriented along the predetermined axis *Ax.*

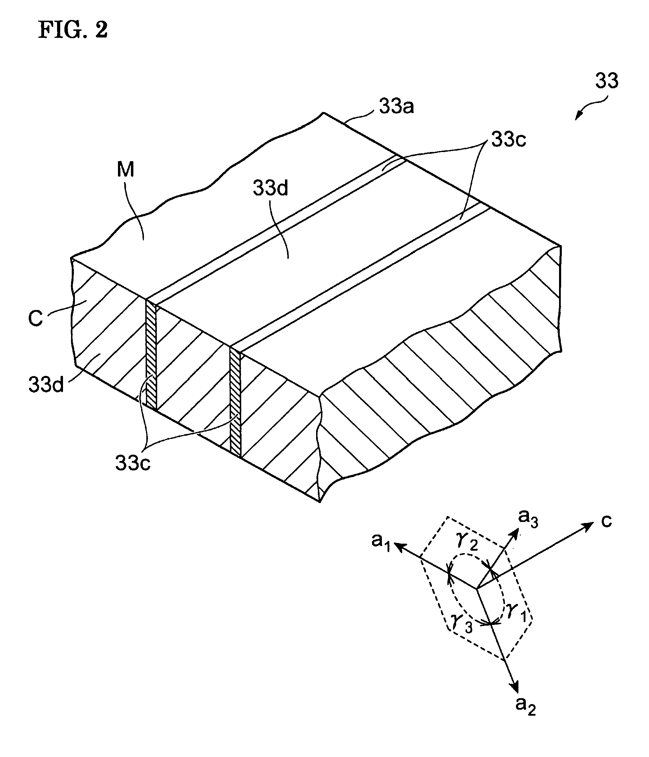

Fig. 2 is a diagram illustrating one example of a gallium nitride substrate for the nitride semiconductor light-emitting device 11. Also in Fig. 2, as in Fig. 1, coordinates for hexagonal crystal are illustrated. In Fig. 2, a *c*-plane is represented with referential mark "*C*", and the *m*-plane is represented with referential mark "*M.*" A first surface 33a of a gallium nitride substrate 33 of the one example has: a first area in which first regions (high-dislocation regions) 33*c* having a relatively high threading dislocation density appears; and a second area in which second regions (low-dislocation regions) 33*d* having a relatively low threading dislocation density appear. The first regions 33*c* and second regions 33*d* are alternately arranged, and on the first surface 33*a*, the first area is in the form of stripes. Most of threading dislocations runs in the *c*-axis direction. A semiconductor grown onto the second regions 33*d* appearing on the *m*-plane principal face is lowered in threading dislocation density. It should be understood that, as has been already explained, the first surface 33*a* of the gallium nitride substrate 33 may be inclined at a certain angle with respect to the *m*-plane.

On a *c*-plane, threading dislocation density in the second regions 33*d* is preferably 1 × 10⁷ cm⁻² or less, for example. Because the second regions 33*d* in which threading dislocation density is 1 × 10⁷ cm⁻² or less appear on the *m*-plane principal face, the semiconductor grown onto the second regions 33dis made very low in threading dislocation density.

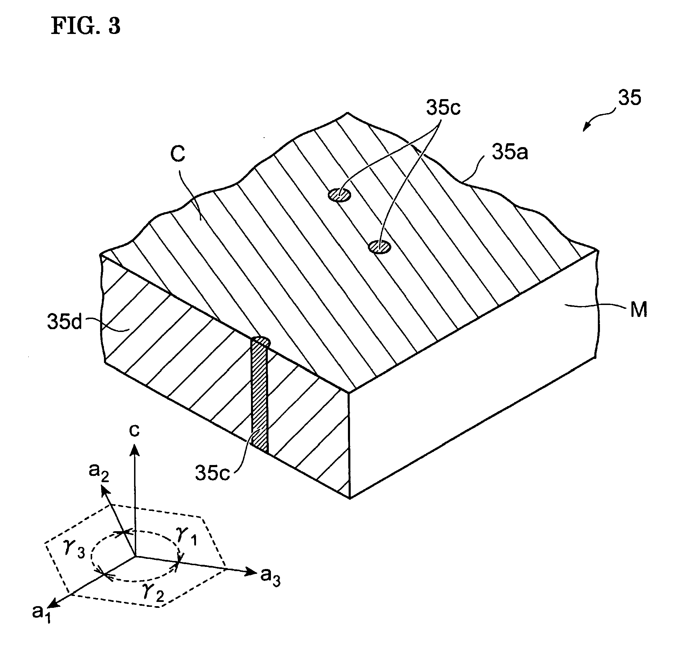

Fig. 3 is a diagram illustrating another example of the gallium nitride substrate for the nitride semiconductor light-emitting device 11. Also in Fig. 3, as in Fig. 1, coordinates for hexagonal crystal are illustrated. In Fig. 3, a *c*-plane is represented with referential mark "*C*", and the *m*-plane is represented with referential mark "*M.*" A first surface 35a of a gallium nitride substrate 35 in the one example has: a first area in which first regions (high-dislocation regions) 35*c* having a relatively high threading dislocation density appears; and a second area in which a second region (low-dislocation region) 35*d* having a relatively low threading dislocation density appears. The first regions 35*c* are arranged inside the second region 35*d*. Therefore, on the first surface 35*a*, the first area is arranged in the form of dots inside the second area. Most of threading dislocations runs in the *c*-axis direction. A semiconductor grown onto the second region 35*d* appearing on the *m*-plane principal face is lowered in threading dislocation density. It should be understood that, as has been already explained, the first surface 35*a* of the gallium nitride substrate 35 may be inclined at a certain angle with respect to the *m*-plane. On a *c*-plane, threading dislocation density in the second region 35*d* is preferably 1 × 10⁷ cm⁻² or less, for example. Slicing off the *m*-plane so that the first regions (high-dislocation regions) 35*c* do not appear on the first surface 35*a* enables fabricating substrates in which the second region (low-dislocation region) 35*d* appears alone on the first surface 35*a*. The appearance of the second region 35*d* in which threading dislocation density is 1 × 10⁷ cm⁻² or less on the *m*-plane principal face makes the semiconductor grown onto the second region 35dvery low in threading dislocation density.

### Embodiment 1

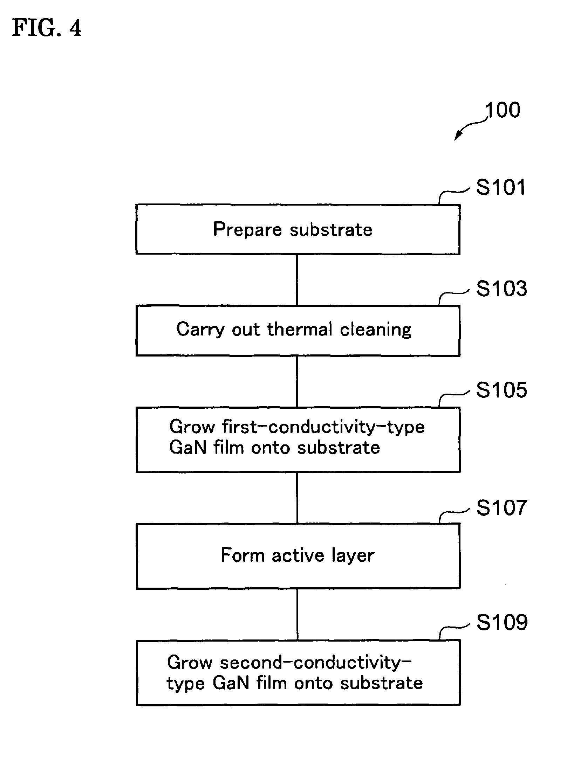

As described below, light-emitting devices including an active layer provided so as to emit light having a wavelength ranging from 440 nm to 550 nm inclusive can be fabricated. In this embodiment, a blue light-emitting device was fabricated by metalorganic vapor phase epitaxy. As materials in metalorganic vapor phase epitaxy, trimethyl gallium, trimethylaluminum, trimethyl indium, ammonia, monosilane, and cyclopentadienyl magnesium were utilized. Fig. 4 is a flow chart representing a flow 100 of major steps for fabricating light-emitting devices.

As represented in Fig. 4, in step *S*101, a substrate constituted of hexagonal Al*_{z}*Ga_{1-*z*}N semiconductor (0 ≤ *z* ≤ 1) is prepared. In this embodiment, an n-type GaN crystal, grown in the (0001) direction, having along the *c*-plane a low-defect region in which threading dislocation density was less than 1 × 10⁶ cm⁻² and a defect-concentrating region distributed in the form of stripes was sliced to form a GaN freestanding crystal, and then the GaN freestanding crystal was polished to fabricate an *m*-plane GaN (10-10) substrate.

In step *S*103, prior to first-conductivity-type gallium nitride semiconductor film formation, *m*-plane GaN substrate is heat-treated while gas containing ammonia and hydrogen is supplied. For this step, the n-type *m*-plane GaN substrate was placed on a susceptor, and with pressure in a furnace being controlled to 30 kPa, ammonia and hydrogen were supplied to the furnace interior, to carry out cleaning for 10 minutes at the substrate temperature of 1,050 degrees Celsius. Due to this heat treatment, planar substrate surfaces are readily obtained, and semiconductor light-emitting devices having more preferable emission properties can be fabricated.

In step *S*105, first-conductivity-type gallium nitride semiconductor film is consequently formed onto substrate principal face. In this embodiment, the substrate temperature was raised to 1,100 degrees Celsius, and then an *n*-type Al_{0.12}Ga_{0.88}N layer was grown. For the growth, hydrogen was principally utilized as a carrier gas, and trimethyl gallium (24 µmol/minute), trimethylaluminum (4.3 µmol/minute), ammonia (0.22 mol/minute), and monosilane were supplied. The AlGaN film thickness is 50 nm, for example.

Next, the growth was temporarily suspended to raise the substrate temperature to 1,150 degrees Celsius, and then an n-type GaN layer was grown. For the n-type GaN layer growth, hydrogen was principally utilized as a carrier gas, and trimethyl gallium (244 µmol/minute), ammonia (0.33 mol/minute), and monosilane were supplied. The GaN film has film thickness of 2 µm, for example.

In step *S*107, successively, active layer that emits light having a wavelength ranging from 440 nm to 550 nm inclusive is formed onto first-conductivity-type gallium nitride semiconductor film. For this step, the growth was temporarily suspended to raise the substrate temperature to 880 degrees Celsius, and then an In_{0.01}Ga_{0.99}N barrier layer was grown. The barrier layer thickness is 15 nm, for example. For the barrier layer growth, nitrogen was principally utilized as a carrier gas, and trimethyl gallium (24 µmol/minute), trimethyl indium (1.6 µmol/minute), and ammonia (0.27 mol/minute) were supplied. After the InGaN barrier layer was grown, the substrate temperature was dropped to 780 degrees Celsius, and then an In_{0.27}Ga_{0.73}N well layer was grown. The well-layer thickness is 4 nm, for example. For the well layer growth, nitrogen was principally utilized as a carrier gas, and trimethyl gallium (24 µmol/minute), trimethyl indium (24 µmol/minute), and ammonia (0.36 mol/minute) were supplied. The un-doped barrier layer growth and un-doped well layer growth were repeated to form, for example, a 6-period quantum well layer.

In step *S*109, next, second-conductivity-type gallium nitride semiconductor film is formed onto active layer. For this step, the growth was suspended again to raise the substrate temperature to 1,050 degrees Celsius, and then a *p*-type Al_{0.15}Ga_{0.85}N electron blocking layer was grown. For the electron blocking layer growth, hydrogen was principally utilized as a carrier gas, and trimethyl gallium (24 µmol/minute), trimethylaluminum (2.3 µmol/minute), ammonia (0.22 mol/minute), and cyclopentadienyl magnesium were supplied. The electron blocking layer thickness is, for example, 20 nm.

After the growth of the *p*-type AlGaN electron blocking layer, a *p*-type GaN layer was grown. For the GaN layer growth, hydrogen was principally utilized as a carrier gas, and trimethyl gallium (99 µmol/minute), ammonia (0.22 mol/minute), and cyclopentadienyl magnesium were supplied. The GaN layer thickness is, for example, 25 nm.

After the growth of the *p*-type GaN layer, a *p*-type GaN contact layer was grown. The *p*-type GaN contact layer thickness is 25 nm, for example. For the GaN contact layer growth, hydrogen was principally utilized as a carrier gas, and trimethyl gallium (67 µmol/minute), ammonia (0.22 mol/minute), and cyclopentadienyl magnesium were supplied. Through these steps, an epitaxial substrate for the light-emitting diode (LED) was produced. The *m*-plane of each of the gallium nitride semiconductor films in the epitaxial substrate substantially parallels a plane stretching along the GaN substrate principal face.

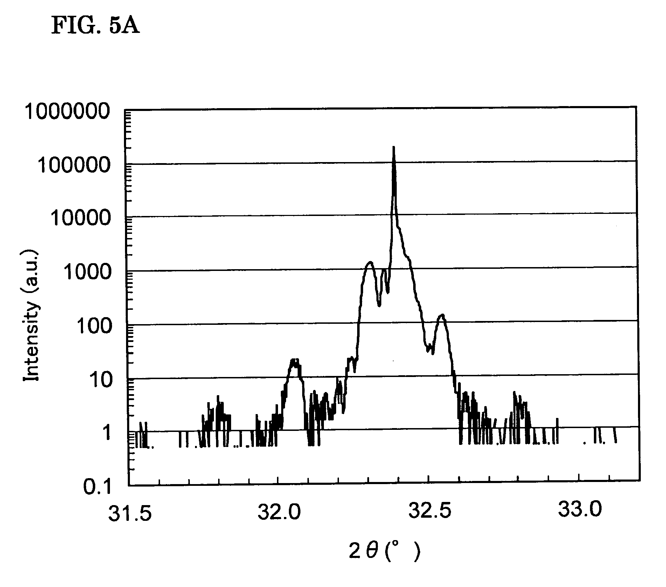

Subsequently, the GaN substrate was taken out from the furnace, and x-ray diffraction characterization (ω - 2θ scan) in the (1-100) plane was carried out. Fig. 5A is a graph showing the results of measuring *x*-ray angular distribution. According to the measurement, the In fraction in the InGaN well layer was approximately 27%. With appropriate metal material, a 400 µm-square (for example, 1.6 × 10⁻³ cm², as electrode surface area) translucent *p*-electrode was formed onto the *p*-type GaN layer in the epitaxial substrates, and an *n*-electrode was formed onto the back side of the GaN substrate. Thereby an LED device was fabricated.

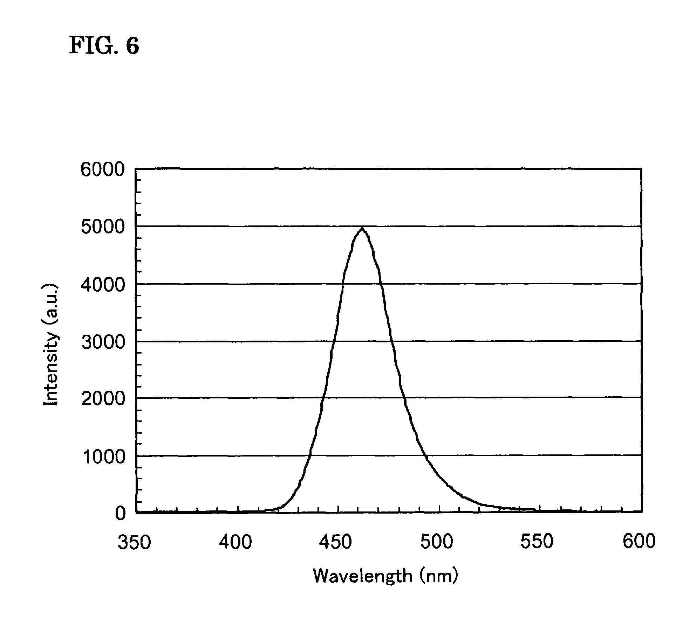

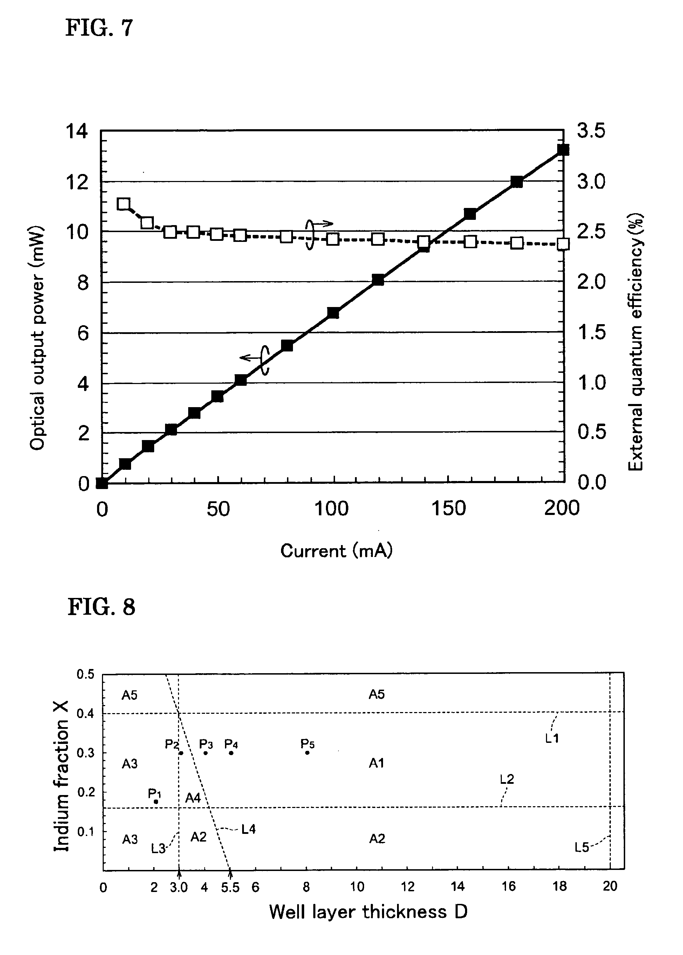

Fig. 6 graphs an emission spectrum obtained by applying pulse electric current to this bare-chip LED at room temperature. Fig. 7 is a graph plotting electric current - characteristic optical output power, and electric current - characteristic external quantum efficiency. The peak emission wavelength is 462 nm, which is pure blue. At a current of 20 mA (current density of 12.5 A/cm²), the optical output power was 1.4 mW and the external quantum efficiency was 2.6%. At a current of 200 mA (current density of 125 A/cm²), the optical output power was 13.2 mW and external quantum efficiency was 2.4%. The chip was molded in an epoxy polymer to fabricate an LED lamp. In post-molding characterization, at a current of 20 mA (current density of 12.5 A/cm²), the peak wavelength was 462 nm, the optical output power was 4.2 mW, and the external quantum efficiency was 7.8%.

In this LED, the first-conductivity-type gallium nitride semiconductor film, active layer, and second-conductivity-type gallium nitride semiconductor film are carried on the GaN substrate principal face, and are arranged successively in the predetermined-axis direction. A semiconductor layer for well, composed of hexagonal In*ₓ*Ga_{1-*x*}N (0.16 ≤ *x* ≤ 0.4, *x*: strained composition), having a first gallium fraction, was grown at a first temperature *T_{w}*, and a semiconductor layer for barrier, composed of hexagonal In*_{y}*Ga_{1-*y*}N (0 ≤ *y* ≤ 0.05, *y* < *x*, *y*: strained composition), having a second gallium fraction, was grown at a second temperature *T_{B}.* The first gallium fraction is lower than the second gallium fraction, and the first temperature *T_{W}* is lower than the second temperature *T_{B}*, with the difference between the first temperature Tw and the second temperature *T_{B}* being 95 degrees or more. According to this method, in formation of active layers in which the *m*-plane of the hexagonal In*ₓ*Ga_{1-*x*}N faces in the predetermined-axis direction, because the difference in growth temperature between the two types of gallium nitride semiconductors in which the first gallium fraction is lower than the second gallium fraction is 95 degrees, increasing indium fraction in the first semiconductor layer makes it applicable as a well layer.

Fig. 8 is a graph showing relationship between indium fraction and well-layer thickness, for an active layer provided so as to emit light having a wavelength ranging from 440 nm to 550 nm inclusive. Active layers in region "*A*1" can emit light having a wavelength ranging from 440 nm to 550 nm inclusive. In region "A2," indium fractions are too low for active layers to emit light having a wavelength of 440 nm or more. In region "*A*3," well layers are too thin for active layers to emit light having a wavelength of 440 nm or more. In region "*A*4, "due to the indium fraction-well-layer thickness relationship, active layers can not emit light having a wavelength of 440 nm or more. In region "A5," indium fractions are too high to produce InGaN crystal having preferable crystallinity In Fig. 8,
line *L*1 : *x* = 0.4,
line *L*2 : *x* = 0.16,
line *L*3 : *D* = 3,
line *L*4 : *x* = -0.16 × D + 0.88, and
line *L*5 : *D* = 20.
Points *P*₁ to *P*₅ represent points where wavelengths of 395 nm, 420 nm, 460nm, 474 nm, and 477 nm were respectively measured. As to the indium fraction well-layer thickness relationship for the active layer provided so as to emit light having a wavelength ranging from 440 nm to 550 nm inclusive, the region (including borderlines) surrounded by the lines *L*1 to *L*5 is preferable.

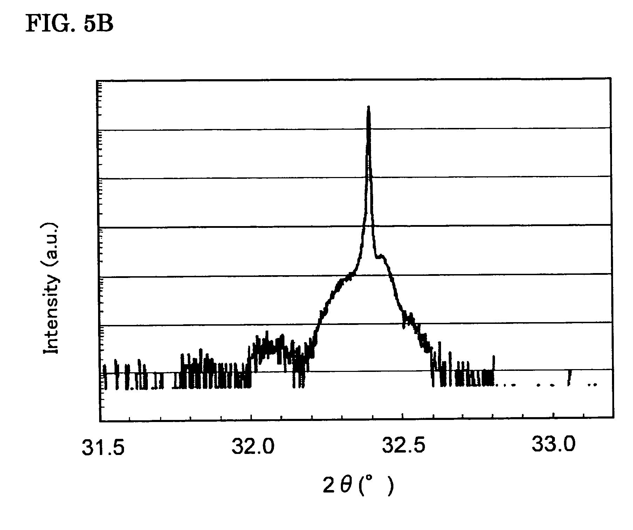

As will be noted from Fig. 8, it is challenging to increase the indium. An epitaxial substrate for LEDs was fabricated by carrying out growth of InGaN well layers with the temperature of the substrate being 750 degrees Celsiuselsius, while having the other conditions be the same as in Embodiment 1 earlier. The epitaxial substrate was blackened in appearance, and no photoluminescence spectrum from its quantum well emission layer was observed. Fig. 5*B* is a graph showing results of x-ray diffraction characterization (ω - 2θ scan) in the epitaxial substrate's (10-10) plane. No satellite peaks in the quantum well emission layer are observed, which means that a quantum-well structure is not formed. The indium fraction presumably exceeds 40%. Thus, increasing the indium fraction in InGaN growth leads to extreme degradation in crystallinity.

In addition, an epitaxial substrate for LEDs was fabricated by setting the InGaN well-layer growth-the trimethyl indium supply volume-to 58 µmol/minute, while having the other conditions be the same as in Embodiment 1 earlier. The epitaxial substrate was blackened in appearance, and any photoluminescence spectrum from its quantum well emission layer was not measured. Results of x-ray diffraction characterization (ω - 2θ scan) of the (10-10) plane demonstrated that no satellite peaks in the quantum well emission layer was observed. That is, a quantum-well structure is not formed. Indium fraction presumably exceeds 40%. Also from these results, it is understood that increasing indium fraction leads to extreme degradation in crystallinity.

Accordingly, in order to fabricate light-emitting devices employing *m*-planes, it is important to control well-layer thickness and indium fraction in the well layer, and to enlarge difference in growth temperature between well layer and barrier layer.

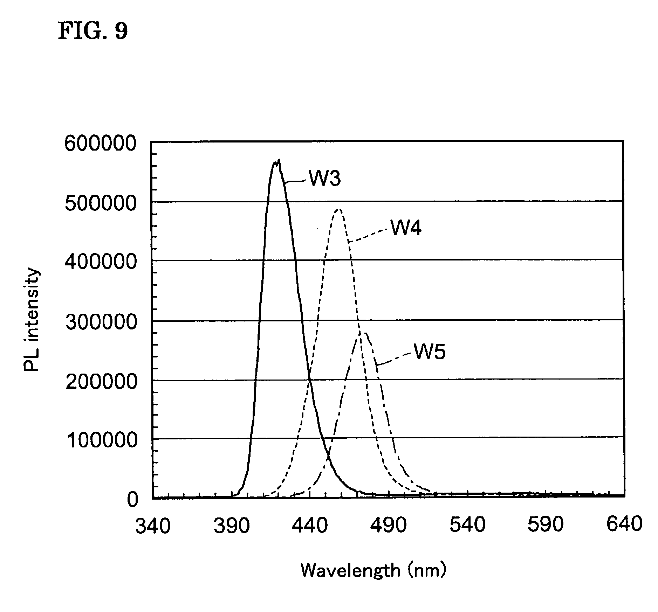

A further embodiment will be explained. Under the same growth conditions as in Embodiment 1, thickness of an InGaN well layer was varied to 3 nm, 4 nm, and 5 nm to fabricate epitaxial substrates of LED structure. Fig. 9 represents relationship between well-layer thickness and PL spectrums *W*₃, *W*₄, and *W*₅. The thicker the well layer, the longer the PL wavelength. With reference to Fig. 9, PL wavelength is 460 nm at well width of 4 nm, and is 475 nm at well width of 5 nm.

As a result of employing an epitaxial substrate to fabricate a LED in the same manner as in Embodiment 1, high optical output power and external quantum efficiency could be obtained as in Embodiment 1. For example, the peak emission wavelength is 470 nm, which is pure blue. At a current of 20 mA (current density of 12.5 A/cm²), the optical output power was 1.6 mW and the external quantum efficiency was 3.0%. At a current of 200 mA (current density of 125 A/cm²), the optical output power was 13.7 mW and the external quantum efficiency was 2.6%. The chip was molded in an epoxy polymer to fabricate a LED lamp. In post-molding characterization, at a current of 20 mA (current density of 12.5 A/cm²), the peak wavelength was 470 nm, the optical output power was 4.8 mW, and the external quantum efficiency was 9.0%.

Substrates except for GaN substrate were employed to fabricate LEDs. Under the same conditions as in Embodiment 1, in place of the n-type *m*-plane GaN (10-10) substrate, onto a 4H-SiC (10-10) substrate and LiAlO₂ (100) substrate, an epitaxial structure for LED was grown to fabricate LEDs. A lot of deposition defects occurred, and very weak output only was obtained.

Furthermore, a *c*-plane GaN substrate was employed to fabricate a LED. As follows, a blue light-emitting device was fabricated by metalorganic vapor phase epitaxy. As materials, trimethyl gallium, trimethylaluminum, trimethyl indium, ammonia, monosilane and cyclopentadienyl magnesium were utilized. The *c*-plane GaN substrate was fabricated by slicing and polishing an n-type GaN, grown in the (0001) direction, having a low-defect region in which threading dislocation density was less than 1 × 10⁶ cm⁻² and defect-concentrating regions distributed in the form of lines.

The n-type *c*-plane GaN (0001) substrate was placed on a susceptor, and with pressure in an furnace being controlled to 30 kPa, ammonia and hydrogen were introduced into the furnace, to carry out cleaning for 10 minutes at the substrate temperature of 1,050 degrees Celsius. After that, the substrate temperature was raised to 1,100°C, and then principally utilizing hydrogen as a carrier gas, trimethyl gallium (24 µmol/minute), trimethylaluminum (4.3 µmol/minute), ammonia (0.22 mol/minute), and monosilane were introduced to grow a 50 nm-thick n-type AlGaN layer (Al fraction: 12%). Next, the growth was temporarily suspended to raise the substrate temperature to 1,150 degrees Celsius, and then principally utilizing hydrogen as a carrier gas, trimethyl gallium (244 µmol/minute), ammonia (0.33 mol/minute), and monosilane were introduced to grow a 2 µm-thick n-type GaN layer.

Next, the growth was temporarily suspended to drop the substrate temperature to 880 degrees Celsius, and then principally utilizing nitrogen as a carrier gas, trimethyl gallium (24 µmol/minute), trimethyl indium (1.6 µmol/minute), and ammonia (0.27 mol/minute) were introduced to grow a 15 nm-thick InGaN barrier layer (In fraction: 1%). After the barrier layer growth, the substrate temperature was dropped to 800 degrees Celsius, and principally utilizing nitrogen as a carrier gas, trimethyl gallium (16 µmol/minute), trimethyl indium (13 µmol/minute), and ammonia (0.36 mol/minute) were introduced, to grow a 3 nm-thick InGaN well layer. These steps were repeated to form a 6-period quantum well emission layer.

Subsequently, the growth was suspended again to raise the substrate temperature to 1,050 degrees Celsius, and then principally utilizing hydrogen as a carrier gas, trimethyl gallium (17 µmol/minute), trimethylaluminum (2.8 µmol/minute), ammonia (0.22 mol/minute) and cyclopentadienyl magnesium were introduced to grow a 20 nm-thick *p*-type AlGaN electron blocking layer (Al fraction: 18%). Subsequently, principally utilizing hydrogen as a carrier gas, trimethyl gallium (99 µmol/minute), ammonia (0.22 mol/minute) and cyclopentadienyl magnesium were introduced to grow a 25 nm-thick *p*-type GaN layer. Next, principally utilizing hydrogen as a carrier gas, trimethyl gallium (67 µmol/minute), ammonia (0.22 mol/minute) and cyclopentadienyl magnesium were introduced to grow a 25 nm-thick *p*-type GaN contact layer.

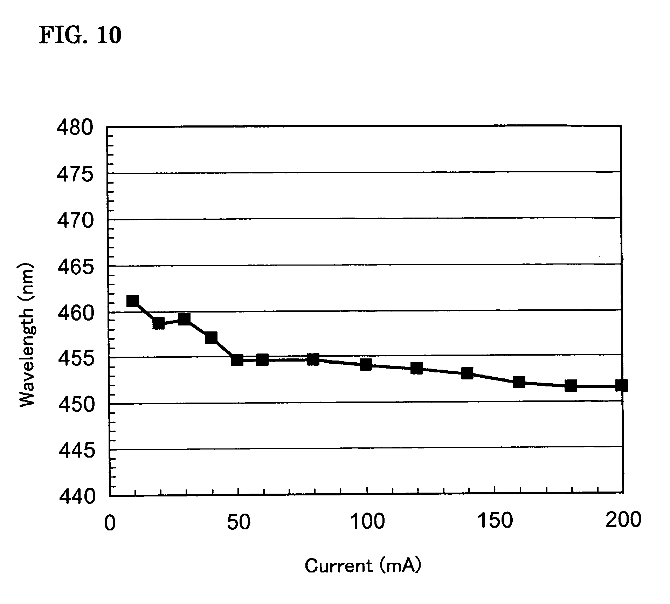

After that, the GaN substrate was taken out from the furnace interior to carry out x-ray diffraction characterization (ω - 2θ scan), with the result that In fraction in the InGaN well layer was approximately 10%. In this epitaxial structure for LED, with appropriate metal material, a 400 µm-square (electrode surface area: 1.6 x 10⁻³ cm²) translucent *p*-electrode was formed onto the *p-*type GaN layer, and an *n*-electrode was formed onto the back side of the GaN substrate, to fabricate an LED device. Although as a result of applying pulse current to the LED with a bare chip at a room temperature, high emission efficiency with wavelength of 460 nm, and with pure blue color was obtained, blue shift of emission wavelength with increasing electric current was observed as shown in Fig. 10. On the other hand, in the LED of Embodiment 1, blue shift of emission wavelength with increasing electric current was not observed.

While principles of the present invention in preferred embodiments have been illustrated and described, it will be recognized by persons skilled in the art that the present invention can be altered in terms of arrangement and details without departing from such principles. The present invention is not limited to the specific configurations disclosed in the present embodiments. Accordingly, the rights in the scope of the patent claims, and in all modifications and alterations deriving from the scope and the spirit thereof, are claimed.

## Claims

1. A nitride semiconductor light-emitting device, furnished with:
a gallium nitride semiconductor region of a first conductivity type;
a gallium nitride semiconductor region of a second conductivity type; and
an active layer provided between the first-conductivity-type gallium nitride semiconductor region and the second-conductivity-type gallium nitride semiconductor region, the active layer being provided so as to emit light of wavelength in the band from 440 nm to 550 nm inclusive; **characterized in that**
the active layer includes a well layer composed of hexagonal In*ₓ*Ga_{1-*x*}N (0.16 ≤ *x* ≤ 0.4, indium fraction *x*: strained composition),
the well-layer thickness D is greater than 3 nm,
the well-layer thickness D is 20 nm or less,
the thickness D by the indium fraction *x* lies in the relationship *x* ≥ -0.16 × D + 0.88,
the first-conductivity-type gallium nitride semiconductor region, the active layer, and the second-conductivity-type gallium nitride semiconductor region are arranged along a predetermined-axis, and
the *m*-plane of the hexagonal In*ₓ*Ga_{1-*x*}N is oriented along the predetermined axis.

2. The nitride semiconductor light-emitting device set forth in claim 1, **characterized in that** the active layer includes a barrier layer composed of hexagonal In*_{y}*Ga_{1-*y*}N (0 ≤ *y* ≤ 0.05, *y*: strained composition).

3. The nitride semiconductor light-emitting device set forth in claim 1 or claim 2, further including a substrate composed of hexagonal Al*_{z}*Ga_{1-*z*}N semiconductor (0 ≤ *z* ≤ 1), and **characterized in that**
the first-conductivity-type gallium nitride semiconductor region, the active layer, and the second-conductivity-type gallium nitride semiconductor region are carried on the principal face of the substrate.

4. The nitride semiconductor light-emitting device set forth in claim 3, **characterized in that** the substrate principal face is misoriented at a given off-axis angle (-2° ≤ θ ≤ +2°) from the *m*-plane.

5. The nitride semiconductor light-emitting device set forth in claim 3, **characterized in that**:
threading dislocations in the substrate extend in the *c*-axis direction; and
the density of threading dislocations crossing the substrate's *c*-plane is 1 × 10⁷ cm⁻² or less.

6. The nitride semiconductor light-emitting device set forth in claim 3, **characterized in that**:
the substrate includes a first region in which the density of threading dislocations extending in the *c*-axis direction is greater than a first threading dislocation density, and a second region in which the density of threading dislocations extending in the *c*-axis direction is less than the first threading dislocation density; and
the first and second regions appear on the substrate principal face.

7. The nitride semiconductor light-emitting device set forth in claim 6, **characterized in that** the threading dislocation density in the second region is less than 1 × 10⁷ cm⁻².

8. A nitride semiconductor light-emitting device fabricating method, furnished with:
a step of preparing a substrate composed of hexagonal Al*_{z}*Ga_{1-*z*}N semiconductor (0 ≤ *z* ≤ 1);
a step of forming a gallium nitride semiconductor film of a first conductivity type onto the principal face of the substrate;
a step of forming onto the first-conductivity-type gallium nitride semiconductor film an active layer such as to emit light of wavelength in the band from 440 nm to 550 nm inclusive; and
a step of forming onto the active layer a gallium nitride semiconductor film of a second conductivity type; **characterized in that**
the first-conductivity-type gallium nitride semiconductor film, the active layer, and the second-conductivity-type gallium nitride semiconductor film are arranged on the substrate principal face along a predetermined axis,
in the active-layer forming step, a first semiconductor layer, composed of hexagonal In*ₓ*RGa_{1-*x*}N (0.16 ≤ *x* ≤ 0.4, *x*: strained composition), having a first gallium fraction is grown at a first temperature, and
in the active layer forming step, a second semiconductor layer, composed of hexagonal In*_{y}*Ga_{1-*y*}N (0 ≤ *y* ≤ 0.05, *y < x, y*: strained composition), having a second gallium fraction is grown at a second temperature;
the first gallium fraction is lower than the second gallium fraction;
the first temperature is lower than the second temperature;
the difference between the first temperature and the second temperature is 95 degrees or more; and
the *m*-plane of the hexagonal In*ₓ*Ga_{1-*x*}N is oriented along the predetermined axis.

9. The method set forth in claim 8, **characterized in that** from hexagonal Al*_{z}*Ga_{1-*z*}N semiconductor crystal (0 ≤ *z* ≤ 1) grown *c*-axis oriented, the substrate is sliced so as to intersect the *m*-axis, and the substrate principal face is polish-processed and stretches paralleling a plane that intersects the *m*-axis.

10. The method set forth in claim 8 or claim 9, **characterized in that**:
the substrate includes a plurality of first regions in which the density of threading dislocations extending in the *c*-axis direction is greater than a first threading dislocation density, and a plurality of second regions in which the density of threading dislocations extending in the *c*-axis direction is less than the first threading dislocation density;
the first and second regions are arranged in alternation; and
the first and second regions appear on the substrate principal face.

11. The method set forth in claim 10, **characterized in that** the threading dislocation density in the second regions is less than 1 × 10⁷ cm⁻².

12. The method set forth in claim 8, **characterized in that** the substrate principal face is misoriented at an off-axis angle (2° ≤ θ ≤ +2°) from the *m*-plane.

13. A method as set forth in any of claim 8 through claim 12, **characterized in** being further furnished with a step of, in advance of the formation of the first-conductivity-type gallium nitride semiconductor film, heat-treating the substrate while supplying thereto a gas containing ammonia and hydrogen.
